# EUROPEAN PATENT APPLICATION

(11) **EP 4 757 516 A1**
(43) Date of publication of application: **10.06.2026**
(21) Application number: 25218973.3
(22) Date of filing: 27.11.2025
(51) Int. Cl.: H05K 7/20

(54) **ELECTRICAL DEVICE, POWER SUPPLY MODULE, ELECTRIC DRIVE SYSTEM AND VEHICLE**

(30) Priority: 03.12.2024 CN 202422979047 U
(71) Applicant: Valeo eAutomotive Shenzhen Co., Ltd, Shenzhen Guangdong 518128 (CN)
(72) Inventor: ZHU, Yuncong, Shenzhen, 518128 (CN); SHEN, Jiawen, Shenzhen, 518128 (CN)
(74) Representative: Valeo Powertrain Systems

(57) **Abstract**

The present invention discloses an electrical apparatus, comprising: a heat dissipation device, the heat dissipation device comprising a main body and a cooling circuit for circulating a cooling medium, the main body comprising at least one side wall, the cooling circuit being arranged in the at least one side wall; and at least one circuit board assembly, comprising a substrate and a heat-generating element that is arranged on the substrate, wherein the substrate comprises a first side and a second side that are opposite each other, the heat-generating element being arranged on the first side, a welding part being provided on the second side, and the welding part being welded to a corresponding side wall of the main body of the heat dissipation device. Also disclosed is a power supply module, comprising the abovementioned electrical apparatus. Also disclosed is an electric drive system, comprising the abovementioned electrical apparatus or the abovementioned power supply module. Also disclosed is a vehicle, comprising the abovementioned electrical apparatus or the abovementioned power supply module or the abovementioned electric drive system.

## Description

### TECHNICAL FIELD

The present disclosure relates to an electric drive system of a vehicle, in particular an electric vehicle or a hybrid vehicle. The present disclosure in particular relates to an electrical apparatus, an electric drive system comprising the electrical apparatus, and a vehicle comprising the electrical apparatus or the electric drive system.

### BACKGROUND

As electric vehicles and hybrid vehicles have developed, higher requirements have been set for the cooling of power devices in electric drive systems. At present, circuit boards that have power devices, such as MOSFETs and IGBTs, in electric drive systems are generally arranged around a peripheral side wall of a heat dissipation device, and this generally requires the use of adhesive glue and a metal elastic clamp, for example, and a plastic support for ensuring electrical insulation between the elastic clamp and the heat dissipation device and holding the elastic clamp, in order to position the circuit board relative to the peripheral side wall of the heat dissipation device. This results in a large number of components, high material costs, a high defect rate, low production efficiency and a high production cost. In addition, fixing devices such as elastic clamps may suffer from fatigue problems due to frequent compression. More specifically, during vehicle driving, power devices may be constantly subjected to external vibrations, and fixing devices such as elastic clamps are prone to lose elasticity or even fail under varying loads. This causes poor heat dissipation due to an inability to press the power device onto the heat dissipation device, resulting in reduced power consumption or failure. Moreover, the design pressure of the elastic clamp is determined by a design compression amount, the thickness of a device on the heat dissipation substrate, and the arrangement position thereof. The specifications of different devices are often inconsistent, which necessitates the redesign, simulation and measurement of a corresponding elastic clamp. These factors that cannot be precisely controlled will cause large deviations in the pressure of the elastic clamp.

Thus, a new solution is still needed to at least partially overcome the abovementioned problems in the prior art.

### SUMMARY OF THE INVENTION

To this end, according to one aspect of the present disclosure, an electrical apparatus is proposed. According to an embodiment, the electrical apparatus comprises:
a heat dissipation device, comprising:
   a main body, the main body comprising at least one side wall;
   a cooling circuit for circulating a cooling medium, the cooling circuit being arranged in the at least one side wall;
at least one circuit board assembly, comprising a substrate and a heat-generating element arranged on the substrate,
wherein the substrate comprises a first side and a second side that are opposite each other, the heat-generating element being arranged on the first side, a welding part being provided on the second side, and the welding part being welded to a corresponding side wall of the main body of the heat dissipation device.

Thus, in the electrical apparatus of the present disclosure, the substrate is held and fixed relative to the corresponding side wall of the main body of the heat dissipation device by means of the welding part arranged on the substrate and by means of welding, thereby allowing fixing devices, such as an elastic clamp, that must be used in the prior art to be dispensed with, reducing the number of components, and therefore simplifying assembly and increasing production efficiency, and therefore enhancing cost benefits. In addition, welding allows adaptation to substrates and heat-generating elements of different specifications. Furthermore, welding is able to effectively prevent loosening of the substrate and the heat-generating element due to external vibrations, ensuring the stability of product performance.

According to various embodiments, the electrical apparatus proposed in the present disclosure may further comprise one or more of the following further developments.

In some embodiments, the welding part is arranged on at least one portion of a peripheral edge part of the substrate. This facilitates the implementation of welding.

In some embodiments, the welding part is arranged on the entire peripheral edge part of the substrate.

In some embodiments, the substrate is provided with an electrically insulating part between the welding part and an electrically conductive part of the substrate. The electrically insulating part is configured to ensure that a sufficient electrical insulation distance is present between the welding part and the electrically conductive part of the substrate, thereby preventing the conduction of electric current from the electrically conductive part to the welding part.

In some embodiments, the heat-generating element is arranged at the electrically conductive part.

In some embodiments, heat dissipation grease is provided between the second side of the substrate and a corresponding side wall of the main body of the heat dissipation device. The heat dissipation grease is configured so as to promote the transmission of heat from the substrate to the heat dissipation device in one aspect, and ensure that the second side of the substrate fits properly to the side wall of the main body of the heat dissipation device in another aspect, thereby further enhancing the heat dissipation effect.

In some embodiments, the heat dissipation grease may be silicone grease.

In some embodiments, the substrate is a metal substrate. The metal substrate may be an aluminium substrate or a copper substrate.

Another aspect of the present disclosure proposes a power supply module, which comprises the electrical apparatus according to any one of the embodiments above, and therefore has corresponding advantages and benefits.

Another aspect of the present disclosure proposes an electric drive system, comprising the electrical apparatus according to any one of the embodiments above or the power supply module as described above, and therefore has corresponding advantages and benefits.

Another aspect of the present disclosure proposes a vehicle, comprising the electrical apparatus according to any one of the embodiments above, the power supply module as described above or the electric drive system as described above.

### BRIEF DESCRIPTION OF THE DRAWINGS

In order to explain the technical solution of embodiments of the present disclosure more clearly, the drawings that need to be used in the embodiments will be briefly described below. It should be understood that the drawings below show only some embodiments of the present disclosure, so they should not be regarded as limiting the scope. Those skilled in the art could obtain other related drawings based on these drawings without inventive effort. In the drawings:
Fig. 1 is a three-dimensional exploded view of a portion of an electrical apparatus according to an exemplary embodiment;
Fig. 2 is a side view of an electrical apparatus according to an exemplary embodiment.

### DETAILED DESCRIPTION OF EMBODIMENTS

An electrical apparatus, an electric drive system and a vehicle according to embodiments of the present disclosure are described in detail below with reference to the drawings. In order to make the objectives, technical solutions and advantages of the present practical disclosure clearer, the technical solutions in the embodiments of the present disclosure will be clearly and completely described below in conjunction with the drawings in the embodiments of the present disclosure; obviously, the embodiments described are some, not all, of the embodiments of the present disclosure.

Thus, the detailed description below of embodiments of the present disclosure provided in conjunction with the drawings is not intended to limit the claimed scope of the present disclosure, and merely shows selected embodiments of the present disclosure. All other embodiments obtained by those skilled in the art on the basis of the embodiments in the present disclosure without inventive effort are included in the scope of protection of the present disclosure.

Unless otherwise defined in the context, the singular includes the plural. Throughout this specification, the terms "comprising", "having", etc. are used herein to specify the existence of the mentioned characteristic, number, step, operation, element, component or combination thereof, without ruling out the existence or addition of one or more other characteristics, numbers, steps, operations, elements, components or combinations thereof.

In addition, although terms including ordinal numbers such as "first", "second", etc. may be used to describe various components, these components are not limited by these terms, which are merely used to differentiate one element from another. For example, without departing from the scope of the present disclosure, a first component may be referred to as a second component and, similarly, a second component may be referred to as a first component.

It should be understood that, in the description of the present utility model, a directional or positional relationship indicated by a term like "upper", "lower", "left", "right", "inner", "outer", etc. is based on a directional or positional relationship shown in the drawings, or is a directional or positional relationship in which the disclosed product is usually placed when used, or is a directional or positional relationship usually understood by those skilled in the art; it is intended only for convenience of description of the present disclosure and brevity of description, instead of indicating or implying that the device or element in question must have a specific direction or be structured or operated in a specific direction, and therefore should not be construed as limiting the present disclosure.

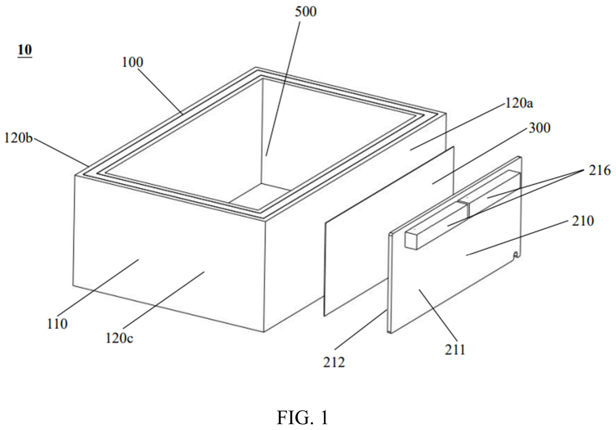

As shown in Figs. 1 - 2, according to one aspect of the present disclosure, an electrical apparatus 10 is proposed. In an exemplary application environment, the electrical apparatus 10 is part of an electric drive system or a power supply module, e.g. part of an electric drive system or an on-board power supply module of an electric vehicle or a hybrid vehicle. It should be understood that the on-board power supply module may be configured to charge an energy storage device (e.g. a supercapacitor or a battery outside the on-board power supply module); it may receive filtered AC inputted from the outside (e.g. from an external charging station or charging apparatus) and rectify and transform this to DC, then deliver this to a load or the energy storage device to charge same. After the on-board power supply module has charged the energy storage device, a power conversion circuit generates driving power on the basis of the power from the energy storage device, to drive an electric motor to rotate.

According to one embodiment, as shown in Figs. 1 - 2, the electrical apparatus 10 comprises a heat dissipation device 100 and at least one circuit board assembly 200. The heat dissipation device 100 comprises a main body 110, the main body 110 comprising at least one side wall 120a, 120b, 120c, a cooling circuit for circulating a cooling medium being arranged in the at least one side wall 120a, 120b, 120c. According to one embodiment, a cooling circuit is arranged in three side walls of the main body 110 of the heat dissipation apparatus 100, i.e. the first side wall 120a, the second side wall 120b and the third side wall 120c, wherein the third side wall 120c is connected to the first side wall 120a and the second side wall 120b. More specifically, the first side wall 120a, the second side wall 120b and the third side wall 120c may form a U-shaped cooling circuit. The cooling medium may be a water and ethanol mixture in a specific embodiment, but is not limited to this. Each circuit board assembly 200 comprises a substrate 210 and a heat-generating element 220 arranged on the substrate 210. Demonstratively, but not exclusively, the substrate 210 is a metal substrate, e.g. an aluminium substrate or a copper substrate. Demonstratively, but not exclusively, the heat-generating element 220 may include an IGBT power transistor and/or a MOSFET. The substrate 210 may comprise a first side 211 and a second side 212 that are opposite each other, the heat-generating element 220 being arranged on the first side 211 of the substrate 210, a welding part 213 being provided on the second side 212 of the substrate 210, and the welding part 213 being constructed to be welded to a corresponding side wall 120a, 120b, 120c of the main body 110 of the heat dissipation device 100. The welding part 213, for example, is a metal part. The welding part 213, for example, may be welded to a side wall 120a, 120b, 120c of the main body 110 of the heat dissipation device 100 by means of laser welding or electric resistance welding.

Thus, in the electrical apparatus 10 of the present disclosure, the substrate 210 is held and fixed relative to the corresponding side wall 120a, 120b, 120c of the main body 110 of the heat dissipation device 100 by means of the welding part 213 arranged on the substrate 210 and by means of welding, thereby allowing fixing devices, such as an elastic clamp, that must be used in the prior art to be dispensed with, reducing the number of components, and therefore simplifying assembly and increasing production efficiency, and therefore enhancing cost benefits. In addition, welding allows adaptation to substrates and heat-generating elements of different specifications. Furthermore, welding is able to effectively prevent loosening of the substrate and the heat-generating element due to external vibrations, ensuring the stability of product performance.

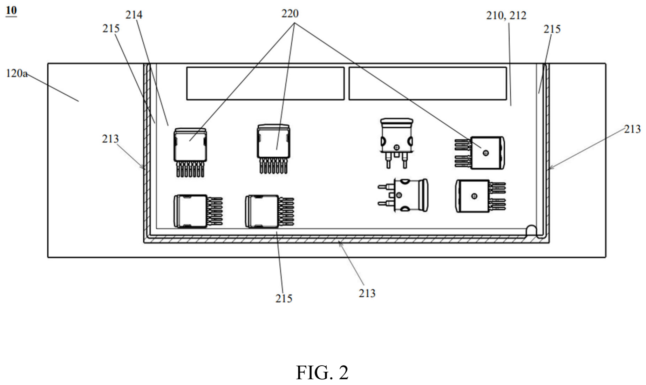

In some embodiments, as shown in Fig. 2, a welding part 213 of a substrate is arranged on at least one portion of a peripheral edge part of the substrate 210. This facilitates the implementation of welding. In some embodiments, a welding part 213 is arranged on an entire peripheral edge part of a substrate 210, which can ensure that the substrate 210 is properly fixed relative to a heat dissipation device 100 and properly fitted to a side wall 120a, 120b, 120c of a main body 110 of the heat dissipation device 100, thereby allowing further improvement of a heat dissipation effect.

In some embodiments, as shown in Fig. 2, a substrate 210 is provided with an electrically insulating part 215 between a welding part 213 and an electrically conductive part 214 of the substrate 210. The electrically insulating part 215 is configured to ensure that a sufficient creepage distance is present between the welding part 213 and the electrically conductive part 214 of the substrate 210, thereby preventing the conduction of electric current from the electrically conductive part 214 to the welding part 213. In a more specific embodiment, as shown in Fig. 2, a heat-generating element 220 is arranged at an electrically conductive part 214 at a first side 211 of the substrate 210.

In some embodiments, as shown in Fig. 1, heat dissipation grease 300 is provided between a second side 212 of a substrate 210 and a corresponding side wall 120a, 120b, 120c of a main body 110 of a heat dissipation device 100. The heat dissipation grease 300 is configured so as to promote the transmission of heat from the substrate 210 to the heat dissipation device 200 in one aspect, and ensure that the second side 212 of the substrate 210 fits properly to the side wall 120a, 120b, 120c of the main body 110 of the heat dissipation device 100 in another aspect, thereby further enhancing the heat dissipation effect. In some embodiments, the heat dissipation grease 300 may be silicone grease.

In some embodiments, as shown in Fig. 1, a main body 110 of a heat dissipation device 100 may comprise a third side wall 120c that connects a first side wall 120a and a second side wall 120b, and a cooling circuit overall forms a U-shape in the first side wall 120a, the second side wall 120b and the third side wall 120c. More specifically, the first side wall 120a, the second side wall 120b and the third side wall 120c of the main body 110 of the heat dissipation device 100 may jointly define an accommodating space 500; this accommodating space 500 may be used for accommodating an electronic/electrical component or device, and therefore allows the accommodated electronic/electrical component or device to dissipate heat.

In some embodiments, a substrate 210 of each circuit board assembly 200 may fit to a corresponding side wall 120a, 120b, 120c of a main body 110 of a heat dissipation apparatus 100 by means of a thermally conductive member. Thus, it is ensured that heat is effectively conducted from the corresponding substrate 210 to the heat dissipation device 100, more specifically a cooling circuit, during operation of the electric device 10. In some embodiments, the thermally conductive member is a thermally conductive adhesive member, such as thermally conductive adhesive glue. The thermally conductive adhesive member allows the substrate 210 to be more securely held in place. Alternatively, the thermally conductive member may be a non-adhesive member; optionally, the adhesive member is at least one of silicone grease or thermally conductive glue.

In some embodiments, a heat-generating element 220 is provided with a heat-dissipation face on a side facing a substrate 210. This further facilitates the dissipation of heat generated by the heat-generating element 220 during operation, more specifically promoting the transmission of heat generated by the heat-generating element 220 during operation to the cooling circuit of the heat dissipation device 100 via the heat dissipation face, for example transmission via the thermally conductive member.

In some embodiments, as shown in Fig. 1, a connector 216 may be provided on a substrate 210, for electrically connecting to an additional circuit board. This allows the functionality of the electrical apparatus 10 to be expanded in a simple manner. The connector 216 may for example comprise one of a pin, a plate contact, a spring beam, a fork contact or an insertion slot. Demonstratively, the additional circuit board may be a main circuit board of the electrical apparatus 10, and, for example, is mainly used for being in an electrical and signal connection with an external component.

A second invention of the present disclosure proposes a power supply module, which comprises the electrical apparatus 10 according to any one of the embodiments above, and therefore has corresponding advantages and benefits.

A third aspect of the present disclosure proposes an electric drive system, comprising the electrical apparatus 10 according to any one of the embodiments above or the power supply module as described above.

A fourth aspect of the present disclosure proposes a vehicle, comprising the electrical apparatus 10 according to any one of the embodiments above, the power supply module as described above or the electric drive system as described above. The vehicle may be an electrified vehicle, such as a battery electric vehicle (BEV), a hybrid electric vehicle (HEV), a plug-in hybrid electric vehicle (PHEV), a range extended EV (REV) or a fuel cell electric vehicle (FCEV). The vehicle may also be a hydrogen-powered vehicle.

Demonstrative embodiments of the electrical apparatus, the electric drive system and the vehicle proposed in the present invention have been described in detail above with reference to preferred embodiments. However, those skilled in the art will understand that, without departing from the concept of the present invention, various modifications and alterations may be made to the specific embodiments above, and various technical features and structures proposed in the present invention may be combined in various ways, without exceeding the scope of protection of the present invention.

The scope of the present disclosure is not defined by the embodiments described above, but by the appended claims and their equivalent scope.

## Claims

1. An electrical apparatus, **characterized in that** the electrical apparatus (10) comprises:
a heat dissipation device (100), comprising:
a main body (110), comprising at least one side wall (120a, 120b, 120c);
a cooling circuit for circulating a cooling medium and arranged in the at least one side wall (120a, 120b, 120c);
at least one circuit board assembly (200), comprising a substrate (210) and a heat-generating element (220) arranged on the substrate (210),
wherein the substrate (210) comprises a first side (211) and a second side (212) that are opposite each other, and the heat-generating element (220) is arranged on the first side (211), and a welding part (213) is provided on the second side (212), and the welding part (213) is welded to a corresponding side wall (120a, 120b, 120c) of the main body (110) of the heat dissipation device (100).

2. The electrical apparatus according to claim 1, **characterized in that** the welding part (213) is arranged on at least one portion of a peripheral edge part of the substrate (210).

3. The electrical apparatus according to claim 2, **characterized in that** the welding part (213) is arranged on the entire peripheral edge part of the substrate (210).

4. The electrical apparatus according to any one of claims 1 to 3, **characterized in that** the substrate (210) is provided with an electrically insulating part (215) between the welding part (213) and an electrically conductive part (214) of the substrate (210).

5. The electrical apparatus according to claim 4, **characterized in that** the heat-generating element (220) is arranged at the electrically conductive part (214).

6. The electrical apparatus according to any one of claims 1 to 3, **characterized in that** heat dissipation grease (300) is provided between the second side (212) of the substrate (210) and a corresponding side wall (120) of the main body (110) of the heat dissipation device (100).

7. The electrical apparatus according to claim 6, **characterized in that** the heat dissipation grease (300) is silicone grease.

8. The electrical apparatus according to any one of claims 1 to 3, **characterized in that** the substrate (210) is a metal substrate.

9. A power supply module, **characterized in that** the power supply module comprises the electrical apparatus (10) according to any one of claims 1 to 8.

10. An electric drive system, **characterized in that** the electric drive system comprises the electrical apparatus (10) according to any one of claims 1 to 8 or the power supply module according to claim 9.

11. A vehicle, **characterized in that** the vehicle comprises the electrical apparatus (10) according to any one of claims 1 to 8, the power supply module according to claim 9 or the electric drive system according to claim 10.
